# FASCICULE DE BREVET EUROPEEN

(11) **EP 2 543 147 B1**
(45) Date de publication et mention de la délivrance du brevet: **29.07.2020**
(21) Numéro de dépôt: 11712961.9
(22) Date de dépôt: 03.03.2011
(51) Int. Cl.: H03L 7/16, H03L 7/10, H03L 7/087

(54) **DISPOSITIF DE SYNTHÈSE DE FRÉQUENCE À BOUCLE DE RÉTROACTION**
VORRICHTUNG FÜR RÜCKKOPPLUNGSSCHLEIFEN-FREQUENZSYSNTHESE
FEEDBACK-LOOP FREQUENCY SYNTHESIS DEVICE

(30) Priorité: 05.03.2010 FR 1051618
(43) Date de publication de la demande: 09.01.2013
(73) Titulaire: Commissariat à l'Énergie Atomique et aux Énergies Alternatives, 75015 Paris (FR)
(72) Inventeur: DE FOUCAULD, Emeric, 38500 Voiron (FR)
(74) Mandataire: Bonnet, Michel
(86) Numéro de dépôt international: PCT/FR2011/050447
(87) Numéro de publication internationale: WO 2011/107715

(56) Documents cités:
- EP-A2- 0 526 227
- EP-A2- 1 819 051
- US-A1- 2004 027 181
- US-A1- 2006 250 192
- US-A1- 2008 224 789
- US-A1- 2009 207 961
- US-A1- 2010 052 751

## Description

La présente invention concerne un dispositif de synthèse de fréquence à boucle de rétroaction.

On connaît de tels dispositifs, par exemple des boucles à phase asservie dites PLL (de l'Anglais « Phase Locked Loop »), généralement appelée boucles à verrouillage de phase, ou des boucles à verrouillage de retard dites DLL (de l'Anglais « Delay Locked Loop » ou « Delay Line Loop »).

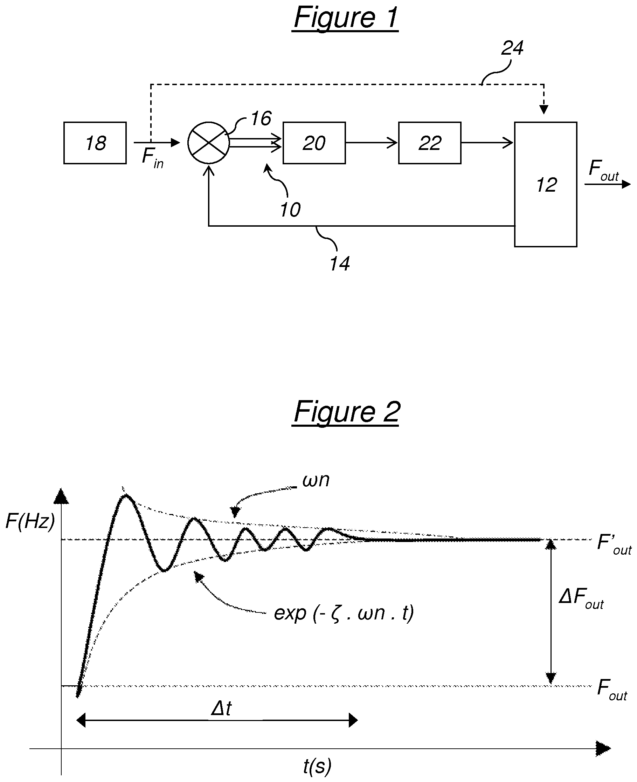

Ces dispositifs peuvent être représentés schématiquement de façon commune par un dispositif tel que celui de la figure 1, comportant un circuit 10 d'asservissement à comparaison de phases, un bloc 12 de conversion de fréquence commandé en tension par le circuit d'asservissement 10 et une boucle de rétroaction 14 pour la fourniture d'un signal issu du bloc 12 de conversion de fréquence au circuit d'asservissement 10.

Plus précisément, dans le cas des PLL et DLL, le circuit d'asservissement 10 comporte un comparateur de phases 16 à deux sorties (généralement appelées UP et DOWN) recevant en entrée un signal de référence à une fréquence Fᵢₙ fourni par une source de fréquence de référence 18 et le signal issu du bloc de conversion de fréquence 12 fourni par la boucle de rétroaction 14. Il comporte en outre une pompe de charges 20 qui injecte ou retire des charges dans un dispositif 22 de filtrage ou de lissage à l'aide de deux sources de courant contrôlées par les sorties UP et DOWN du comparateur de phases 16. Cela permet au circuit d'asservissement de fournir une tension en sortie du dispositif 22 de filtrage ou de lissage qui soit déterminée, par exemple de façon proportionnelle, par la comparaison du signal fourni par la boucle de rétroaction avec le signal de référence.

Pour une PLL, le dispositif 22 est plus particulièrement un filtre et le bloc de conversion de fréquence 12 comporte un oscillateur interne commandé en tension, celle fournie par le circuit d'asservissement 10, pour la fourniture d'un signal de sortie à une fréquence Fₒᵤₜ multiple de la fréquence Fᵢₙ, et un diviseur pour l'obtention, à partir du signal de sortie, d'un signal à la fréquence Fᵢₙ à fournir à la boucle de rétroaction 14. La tension de commande permet de régler finement la fréquence de l'oscillateur interne.

Pour une DLL, le dispositif 22 est plus particulièrement un bloc condensateur de lissage et le bloc de conversion de fréquence 12 comporte une ligne à retard commandée en tension, celle fournie par le circuit d'asservissement 10, pour la génération de P signaux déphasés à la fréquence Fᵢₙ à partir du signal fourni par la source de fréquence de référence 18 via une connexion 24, et un multiplicateur de fréquence recevant ces P signaux déphasés pour la fourniture d'un signal de sortie à une fréquence Fₒᵤₜ multiple de la fréquence Fᵢₙ, plus précisément à la fréquence Fₒᵤₜ = P/2 Fᵢₙ. Le signal fourni au comparateur de phases 16 par la boucle de rétroaction 14 est l'un des P signaux déphasés fournis par la ligne à retard commandée en tension, par exemple le premier. La tension de commande permet de régler finement le déphasage des P signaux générés par la ligne à retard.

Les PLL et les DLL sont ainsi généralement utilisées dans les circuits électroniques en tant que sources de fréquences élevées. En effet, ces dispositifs permettent à partir d'une source à basse fréquence et de haute pureté spectrale (par exemple du quartz émettant à quelques MHz) d'obtenir des signaux à haute fréquence (par exemple quelques GHz) et avec une pureté spectrale de meilleure qualité que les dispositifs générant directement des signaux à haute fréquence.

Concrètement, pour une source de fréquence de référence basse et de haute pureté spectrale Fᵢₙ, on obtient en sortie un signal de bonne pureté spectrale à haute fréquence Fₒᵤₜ = N Fᵢₙ, N étant un facteur multiplicatif. Ce facteur multiplicatif N est généralement variable afin de faire varier les différents canaux des normes utilisées suivant l'application.

Un paramètre important des dispositifs de synthèse de fréquence est le temps Δt d'établissement de leur régime de fonctionnement, c'est-à-dire le temps qu'ils mettent à être fonctionnels, soit au démarrage, soit lors d'un changement de canal (i.e. changement du facteur N). Ce temps Δt perdure pendant un régime transitoire, généralement qualifié de phase d'accrochage, précédant le régime de fonctionnement.

Un exemple de régime transitoire que suit un dispositif de synthèse de fréquence lors d'un changement de canal est illustré sur la figure 2. Lors du passage ΔFₒᵤₜ d'une fréquence Fₒᵤₜ à une fréquence F'ₒᵤₜ, le régime transitoire de fréquence synthétisée suit une enveloppe exponentielle tendant asymptotiquement vers F'ₒᵤₜ à une fréquence de résonance propre ωn pendant la durée Δt.

La durée Δt de la phase d'accrochage dépend des paramètres constitutifs du dispositif de synthèse de fréquence et limite sa réactivité.

La demande de brevet publiée sous le numéro US 2002/0043995 décrit un comparateur de phases dont la structure interne permet de réduire la durée de la phase d'accrochage du dispositif de type PLL ou DLL dans lequel il est utilisé. Grâce à ce comparateur de phases, la fréquence de la source de référence est rapidement en phase avec la sortie du diviseur (cas de la DLL) ou de la ligne à retard commandée en tension (cas de la PLL). Mais cette réduction de la durée de la phase d'accrochage s'obtient au prix d'une complexité largement accrue du comparateur de phases.

La demande de brevet publiée sous le numéro US 2007/0285132 décrit une PLL comportant une pompe de charges sélective reliée à deux comparateurs de phases pour une accélération de l'établissement du régime de fonctionnement. Mais là encore, ce résultat s'obtient au prix d'une complexité des éléments reliant les deux comparateurs de phases à la pompe de charges sélective.

La demande de brevet publiée sous numéro US 2009/0207961 A1 décrit un dispositif de synchronisation de phase comprenant un détecteur de phase digital et un autre détecteur de phase analogique. Le détecteur de phase analogique n'est activé qu'après verrouillage.

Il peut ainsi être souhaité de prévoir un dispositif de synthèse de fréquence à boucle de rétroaction qui présente un temps d'établissement de son régime de fonctionnement le plus court possible tout en s'affranchissant d'au moins une partie des problèmes et contraintes précités.

L'invention a donc pour objet un dispositif de synthèse de fréquence à boucle de rétroaction, comportant un circuit d'asservissement à comparaison de phases, un bloc de conversion de fréquence commandé en tension par le circuit d'asservissement et une boucle de rétroaction pour la fourniture d'au moins un signal issu du bloc de conversion de fréquence au circuit d'asservissement, comportant en outre au moins un autre circuit d'asservissement pour la commande en tension du bloc de conversion de fréquence et au moins une autre boucle de rétroaction pour la fourniture d'au moins un autre signal issu du bloc de conversion de fréquence à cet autre circuit d'asservissement.

Ainsi, en prévoyant d'exploiter en rétroaction au moins un autre signal issu du bloc de conversion pour commander ce dernier en tension à l'aide d'au moins deux circuits d'asservissement à comparaison de phases, on réalise l'asservissement plus souvent de sorte que l'on réduit d'autant le temps d'établissement du régime de fonctionnement du dispositif de synthèse de fréquence. Sachant qu'un circuit d'asservissement à comparaison de phases classique est généralement très simple et de surface très réduite par rapport à la complexité générale et à la surface globale du dispositif de synthèse de fréquence dans lequel il est utilisé, le fait d'en prévoir plusieurs ajoute une complexité et une surface supplémentaires négligeables pour un gain non négligeable.

De façon optionnelle, un dispositif de synthèse de fréquence selon l'invention peut comporter :
- N circuits d'asservissement pour la commande en tension du bloc de conversion de fréquence et N boucles de rétroaction, le bloc de conversion de fréquence étant conçu pour fournir respectivement N signaux déphasés successivement entre eux de 2π/N aux N circuits d'asservissement par l'intermédiaire des N boucles de rétroaction,
- au moins une source de fréquence de référence conçue pour fournir respectivement N signaux de référence déphasés successivement entre eux de 2π/N aux N circuits d'asservissement.

De façon optionnelle également, un dispositif de synthèse de fréquence selon l'invention peut comporter :
- deux circuits d'asservissement et deux boucles de rétroaction, le bloc de conversion de fréquence étant conçu pour fournir respectivement deux signaux en opposition de phase aux deux circuits d'asservissement par l'intermédiaire des deux boucles de rétroaction,
- au moins une source de fréquence de référence conçue pour fournir respectivement deux signaux de référence en opposition de phase aux deux circuits d'asservissement.

De façon optionnelle également, un dispositif de synthèse de fréquence selon l'invention peut comporter une source de fréquence à quartz et un diviseur du signal fourni par la source de fréquence à quartz pour la fourniture des N signaux de référence aux N circuits d'asservissement.

De façon optionnelle également, chaque circuit d'asservissement comporte :
- un comparateur de phases à deux sorties recevant en entrée l'un des signaux de référence et le signal issu du bloc de conversion de fréquence fourni par la boucle de rétroaction correspondante, et
- une pompe de charges recevant en entrée les sorties du comparateur de phase et fournissant en sortie une tension de commande du bloc de conversion de fréquence.

De façon optionnelle également, lorsque le dispositif selon l'invention est de type boucle à verrouillage de phase dite PLL, le bloc de conversion de fréquence comporte un oscillateur commandé en tension disposé en sortie des circuits d'asservissement et un diviseur de tension connecté entre l'oscillateur commandé en tension et les boucles de rétroaction.

Dans ce cas, le dispositif de synthèse de fréquence peut comporter en outre un filtre disposé en entrée de l'oscillateur commandé en tension.

De façon optionnelle également, lorsque le dispositif selon l'invention est de type boucle à verrouillage de retard dite DLL, le bloc de conversion de fréquence comporte une ligne à retard commandée en tension disposée en sortie des circuits d'asservissement et fournissant en sortie des signaux déphasés dont au moins une partie est fournie aux boucles de rétroaction et un multiplicateur de fréquence disposé pour recevoir les signaux déphasés de la ligne à retard commandée en tension et fournir un signal de sortie à fréquence démultipliée.

Dans ce cas, le dispositif de synthèse de fréquence peut comporter en outre un bloc condensateur disposé en entrée de la ligne à retard commandée en tension.

De façon optionnelle également, un dispositif de synthèse de fréquence selon l'invention peut comporter des moyens de déconnexion de tous les circuits d'asservissement sauf un.

L'invention sera mieux comprise à l'aide de la description qui va suivre, donnée uniquement à titre d'exemple et faite en se référant aux dessins annexés dans lesquels :
- la figure 1, déjà décrite, représente schématiquement la structure générale d'un dispositif de synthèse de fréquence à boucle de rétroaction de l'état de la technique,
- la figure 2, déjà décrite, est un diagramme temporel illustrant un paramètre important du dispositif de la figure 1, à savoir le temps d'établissement de son régime de fonctionnement, et
- les figures 3 et 4 représentent schématiquement les structures générales de dispositifs de synthèse de fréquence à boucle de rétroaction selon deux modes de réalisation de l'invention.

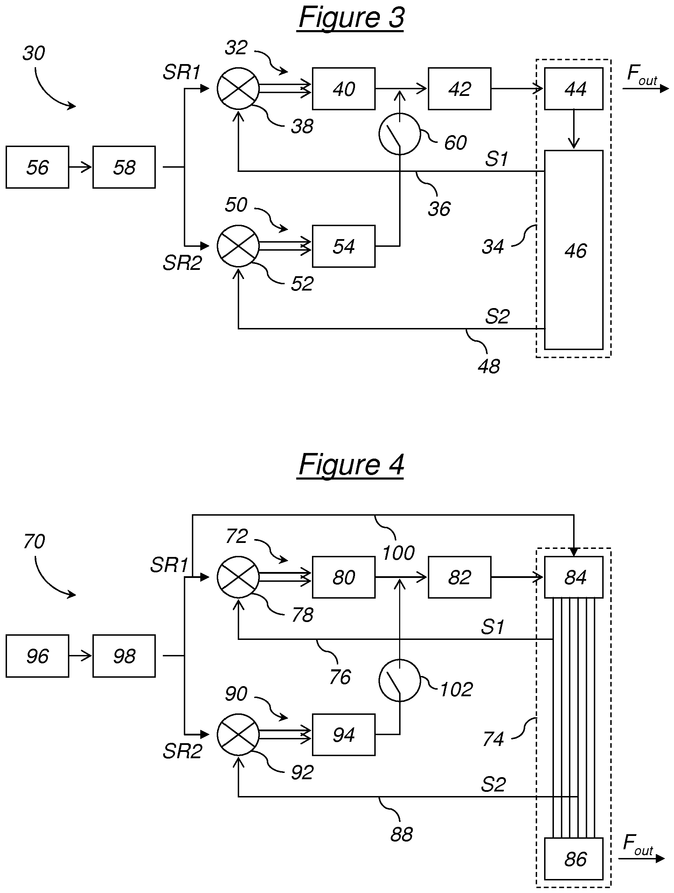

La figure 3 représente schématiquement un dispositif 30 de synthèse de fréquence de type PLL, selon un premier mode de réalisation de l'invention.

Ce dispositif 30 comporte un premier circuit 32 d'asservissement à comparaison de phases, un bloc 34 de conversion de fréquence commandé en tension par le premier circuit d'asservissement 32 et une première boucle de rétroaction 36 pour la fourniture d'un premier signal S1 issu du bloc 34 de conversion de fréquence au premier circuit d'asservissement 32.

Plus précisément, le premier circuit d'asservissement 32 comporte un premier comparateur de phases 38 à deux sorties UP et DOWN recevant en entrée un premier signal de référence SR1 à une fréquence Fᵢₙ et le premier signal S1 fourni par la première boucle de rétroaction 36. Il comporte en outre une première pompe de charges 40 qui injecte ou retire des charges dans un dispositif de filtrage 42 à l'aide de deux sources de courant contrôlées par les sorties UP et DOWN du premier comparateur de phases 38. Cela permet de fournir une tension en sortie du dispositif de filtrage 42 qui soit déterminée, par exemple de façon proportionnelle, par la comparaison du signal S1 avec le signal de référence SR1 pour la commande du bloc de conversion de fréquence 34.

Plus précisément également, le bloc de conversion de fréquence 34 comporte un oscillateur interne 44 commandé par la tension fournie par le dispositif de filtrage 42 pour la fourniture d'un signal de sortie à une fréquence Fₒᵤₜ multiple de la fréquence Fᵢₙ. Il comporte en outre un diviseur 46 pour l'obtention, à partir du signal de sortie, de deux signaux à la fréquence Fᵢₙ, l'un de ces deux signaux étant le signal S1 fourni à la première boucle de rétroaction 36, l'autre étant un signal S2 en opposition de phase avec S1 fourni à une seconde boucle de rétroaction 48. De façon classique, le diviseur 46 remplit en effet les fonctions de diviseur et déphaseur.

Dans le mode de réalisation illustré sur la figure 3, le dispositif 30 de synthèse de fréquence comporte un second circuit 50 d'asservissement à comparaison de phases, pour la commande en tension de l'oscillateur interne 44 du bloc 34 de conversion de fréquence.

Plus précisément, le second circuit d'asservissement 50 comporte un second comparateur de phases 52 à deux sorties UP et DOWN recevant en entrée un second signal de référence SR2, à une fréquence Fᵢₙ et en opposition de phase avec SR1, et le second signal S2 fourni par la seconde boucle de rétroaction 48. Il comporte en outre une seconde pompe de charges 54 qui injecte ou retire des charges dans le dispositif de filtrage 42 à l'aide de deux sources de courant contrôlées par les sorties UP et DOWN du second comparateur de phases 52. Cela permet de fournir une tension en sortie du dispositif de filtrage 42 qui soit déterminée, par exemple de façon proportionnelle, par la comparaison du signal S2 avec le signal de référence SR2 pour la commande du bloc de conversion de fréquence 34.

Les signaux de référence SR1 et SR2 peuvent être fournis par des sources de fréquence de référence indépendantes, mais dans le mode de réalisation envisagé, ils sont fournis par une unique source de référence 56 combinée à un diviseur 58 pour la fourniture des deux signaux SR1 et SR2 en opposition de phase à la fréquence Fᵢₙ. En variante, la source de référence 56 pourrait également directement fournir le signal SR1 à la fréquence Fᵢₙ au premier comparateur de phases 38 et le signal SR2 fourni au second comparateur de phases 52 pourrait être obtenu par une simple inversion de signe de SR1.

En pratique, la source de référence 56 est par exemple un quartz, mais il pourrait aussi s'agir d'un oscillateur de type BAW (de l'Anglais « Bulk Acoustic Wave ») ou de tout autre oscillateur capable d'émettre un signal de haute pureté spectrale.

Enfin, le dispositif 30 comporte des moyens 60 de déconnexion du second circuit d'asservissement 50, par exemple un simple interrupteur commandé ou tout autre commutateur.

Ainsi, en phase transitoire de démarrage ou de changement de canal, c'est-à-dire en phase d'accrochage, la présence des deux circuits d'asservissement 32 et 50 connectés permet de multiplier par deux la fréquence des asservissements (2. Fᵢₙ au lieu de Fᵢₙ) et donc de diviser par deux le temps d'établissement du régime de fonctionnement. En régime de fonctionnement, on ouvre l'interrupteur 60 pour n'asservir le bloc 34 de conversion de fréquences qu'à l'aide du premier circuit d'asservissement 32 et limiter ainsi la consommation d'énergie.

Concrètement, il a été mesuré qu'à l'aide de circuits d'asservissement classiques et simples (un comparateur de phases simple et une pompe de charges), le temps d'établissement du régime de fonctionnement du dispositif de synthèse de fréquence peut être ramené d'environ 500 µs à environ 250 µs. La surconsommation due à la présence de deux circuits d'asservissement est complètement compensée par la réduction du temps d'établissement du régime de fonctionnement. La déconnexion du second circuit d'asservissement 50 en régime de fonctionnement permet en outre de ne pas prolonger cette surconsommation lorsqu'elle n'est plus utile.

Le dispositif 30 décrit précédemment comporte exactement deux circuits d'asservissement associés à deux boucles de rétroaction, mais il est très simple de généraliser l'invention à un dispositif de synthèse comportant :
- N circuits d'asservissement pour la commande en tension du bloc 34 de conversion de fréquence et N boucles de rétroaction, le diviseur/déphaseur 46 du bloc de conversion de fréquence étant conçu pour fournir respectivement N signaux déphasés successivement entre eux de 2π/N aux N circuits d'asservissement par l'intermédiaire des N boucles de rétroaction,
- au moins une source de fréquence de référence conçue pour fournir respectivement N signaux de référence déphasés successivement entre eux de 2π/N aux N circuits d'asservissement.

N peut être égal à 3, 4 voire plus. On peut étendre le nombre de circuits d'asservissement jusqu'à ce que le dispositif de filtrage 42 ne puisse plus, à chaque asservissement, décharger la quantité de charge due à l'asservissement précédent.

Lorsque N est une puissance de 2, il est notamment simple d'obtenir les N signaux de référence déphasés de 2π/N à partir de la source 56 et les N signaux issus du bloc 34 de conversion de fréquence également déphasés de 2π/N à l'aide des diviseurs 58 et 46 qui combinent les fonctions de division et de déphasage.

Avantageusement, le dispositif de synthèse de fréquence à N circuits d'asservissement ainsi obtenu comporte des moyens de déconnexion de tous les circuits d'asservissement sauf un, pour déconnecter tous les circuits d'asservissement sauf un lorsque la phase d'accrochage est terminée.

La figure 4 représente schématiquement un dispositif 70 de synthèse de fréquence de type DLL, selon un second mode de réalisation de l'invention.

Ce dispositif 70 comporte un premier circuit 72 d'asservissement à comparaison de phases, un bloc 74 de conversion de fréquence commandé en tension par le premier circuit d'asservissement 72 et une première boucle de rétroaction 76 pour la fourniture d'un premier signal S1 issu du bloc 74 de conversion de fréquence au premier circuit d'asservissement 72.

Plus précisément, le premier circuit d'asservissement 72 comporte un premier comparateur de phases 78 à deux sorties UP et DOWN recevant en entrée un premier signal de référence SR1 à une fréquence Fᵢₙ et le premier signal S1 fourni par la première boucle de rétroaction 76. Il comporte en outre une première pompe de charges 80 qui injecte ou retire des charges dans un bloc condensateur de lissage 82 à l'aide de deux sources de courant contrôlées par les sorties UP et DOWN du premier comparateur de phases 78. Cela permet de fournir une tension en sortie du bloc condensateur de lissage 82 qui soit déterminée, par exemple de façon proportionnelle, par la comparaison du signal S1 avec le signal de référence SR1 pour la commande du bloc de conversion de fréquence 74.

Plus précisément également, le bloc de conversion de fréquence 74 comporte une ligne à retard 84 commandée par la tension fournie par le bloc condensateur de lissage 82 pour la fourniture de P signaux déphasés à la fréquence Fᵢₙ à partir d'un signal de référence à la fréquence Fᵢₙ, par exemple le signal de référence SR1 fourni non seulement au premier comparateur de phases 78 mais aussi à la ligne à retard 84. Il comporte en outre un multiplicateur de fréquence 86 disposé pour recevoir les P signaux déphasés de la ligne à retard commandée en tension 84 et fournir un signal de sortie à fréquence démultipliée Fₒᵤₜ. Concrètement, Fₒᵤₜ = P/2 Fᵢₙ. On notera qu'il est possible d'obtenir un autre facteur de multiplication, inférieur à P/2, en sélectionnant - par exemple, à l'aide d'un multiplexeur - le nombre de signaux déphasés pris en compte par le multiplicateur de fréquence 86. Deux signaux sont choisis parmi les P signaux déphasés en sortie de la ligne à retard 84. L'un de ces deux signaux est le signal S1 fourni à la première boucle de rétroaction 76, l'autre étant un signal S2 en opposition de phase avec S1 fourni à une seconde boucle de rétroaction 88. On choisit par exemple le premier signal sortant de la ligne à retard pour S1 et le (P/2+1)-ième pour S2.

Dans le mode de réalisation illustré sur la figure 4, le dispositif 70 de synthèse de fréquence comporte un second circuit 90 d'asservissement à comparaison de phases, pour la commande en tension de la ligne à retard 84 du bloc 74 de conversion de fréquence.

Plus précisément, le second circuit d'asservissement 90 comporte un second comparateur de phases 92 à deux sorties UP et DOWN recevant en entrée un second signal de référence SR2, à une fréquence Fᵢₙ et en opposition de phase avec SR1, et le second signal S2 fourni par la seconde boucle de rétroaction 88. Il comporte en outre une seconde pompe de charges 94 qui injecte ou retire des charges dans le bloc condensateur de lissage 82 à l'aide de deux sources de courant contrôlées par les sorties UP et DOWN du second comparateur de phases 92. Cela permet de fournir une tension en sortie du bloc condensateur de lissage 82 qui soit déterminée, par exemple de façon proportionnelle, par la comparaison du signal S2 avec le signal de référence SR2 pour la commande du bloc de conversion de fréquence 74.

Comme dans le mode de réalisation précédent, les signaux de référence SR1 et SR2 peuvent être fournis par des sources de fréquence de référence indépendantes, mais ils sont ici aussi fournis par une unique source de référence 96 combinée à un diviseur 98 pour la fourniture des deux signaux SR1 et SR2 en opposition de phase à la fréquence Fᵢₙ. En variante, la source de référence 96 pourrait également directement fournir le signal SR1 à la fréquence Fᵢₙ au premier comparateur de phases 78 et le signal SR2 fourni au second comparateur de phases 92 pourrait être obtenu par une simple inversion de signe de SR1.

En pratique, la source de référence 96 est par exemple un quartz, mais il pourrait aussi s'agir d'un oscillateur de type BAW (de l'Anglais « Bulk Acoustic Wave ») ou de tout autre oscillateur capable d'émettre un signal de haute pureté spectrale.

Une connexion 100 est établie entre la source de référence 96 (plus précisément la sortie du diviseur 98 dans l'exemple illustré) et l'entrée de la ligne à retard 84 pour la fourniture du signal de référence SR1 à la ligne à retard 84.

Enfin, le dispositif 70 comporte des moyens 102 de déconnexion du second circuit d'asservissement 90, par exemple un simple interrupteur commandé ou tout autre commutateur, pour la même raison que dans le premier mode de réalisation décrit précédemment.

De nouveau, le dispositif 70 décrit dans le second mode de réalisation comporte exactement deux circuits d'asservissement associés à deux boucles de rétroaction, mais il est très simple de généraliser l'invention à un dispositif de synthèse comportant :
- N circuits d'asservissement pour la commande en tension du bloc 74 de conversion de fréquence et N boucles de rétroaction, à partir du moment où N signaux déphasés successivement entre eux de 2π/N peuvent être choisis en sortie de la ligne à retard 84 pour être fournis aux N circuits d'asservissement par l'intermédiaire des N boucles de rétroaction,
- au moins une source de fréquence de référence conçue pour fournir respectivement N signaux de référence déphasés successivement entre eux de 2π/N aux N circuits d'asservissement.

N peut être égal à 3, 4 voire plus. On peut étendre le nombre de circuits d'asservissement jusqu'à ce que le bloc condensateur de lissage 82 ne puisse plus, à chaque asservissement, décharger la quantité de charge due à l'asservissement précédent.

Les N signaux déphasés successivement entre eux de 2π/N choisis en sortie de la ligne à retard 84 sont par exemple les (k.P/N+1)-ièmes signaux sortant de cette ligne à retard 84.

Lorsque N est une puissance de 2, il est notamment simple d'obtenir les N signaux de référence déphasés de 2π/N à partir de la source 96 à l'aide du diviseur 98 qui combine les fonctions de division et de déphasage.

Avantageusement, le dispositif de synthèse de fréquence à N circuits d'asservissement ainsi obtenu comporte des moyens de déconnexion de tous les circuits d'asservissement sauf un, pour déconnecter tous les circuits d'asservissement sauf un lorsque la phase d'accrochage est terminée.

Il apparaît clairement qu'un dispositif de synthèse de fréquence à boucle de rétroaction tel que l'un de ceux décrits précédemment présente une phase d'accrochage nettement plus courte que celle des dispositifs connus.

Il peut ainsi être avantageusement utilisé pour la conception d'émetteurs/récepteurs radiofréquence à changements de fréquences, par exemple les systèmes multistandards, reconfigurables et/ou de radio opportuniste, notamment dans le domaine de la synthèse de fréquences numériques.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. L'invention est limitée par les revendications annexées.

## Revendications

1. Dispositif (30 ; 70) de synthèse de fréquence à boucle de rétroaction, comportant :
- un premier circuit (32 ; 72) d'asservissement à comparaison de phases recevant un premier signal de référence à une fréquence de référence, un bloc (34 ; 74) de conversion de fréquence commandé en tension par le premier circuit d'asservissement (32 ; 72) et conçu pour la fourniture d'un signal de sortie à une fréquence de sortie multiple de la fréquence de référence, et un circuit de rétroaction (36 ; 76) pour la fourniture d'au moins un signal (S1) issu du bloc (34 ; 74) de conversion de fréquence au premier circuit d'asservissement (32 ; 72),
- au moins un autre circuit d'asservissement (50 ; 90) recevant au moins un autre signal de référence à la fréquence de référence pour la commande en tension du bloc (34 ; 74) de conversion de fréquence et au moins un autre circuit de rétroaction (48 ; 88) pour la fourniture d'au moins un autre signal (S2) issu du bloc (34 ; 74) de conversion de fréquence à cet autre circuit d'asservissement (50 ; 90),
**caractérisé en ce que**
- ledit premier signal de référence et ledit autre signal de référence étant déphasés entre eux d'un déphasage prédéterminé,
- lesdits signaux (S1, S2) issus du bloc (34 ; 74) de conversion de fréquence étant déphasés entre eux du même déphasage prédéterminé,
dans lequel chaque circuit d'asservissement (32, 50 ; 72, 90) comporte un comparateur de phases (38, 52 ; 78, 92) à deux sorties recevant en entrée l'un des signaux de référence (SR1, SR2) et son signal correspondant (S1, S2) issu du bloc (34 ; 74) de conversion de fréquence fourni par le circuit de rétroaction (36, 48 ; 76, 88) correspondant,
- chaque circuit d'asservissement (32, 50 ; 72, 90) comporte en outre une pompe de charges (40, 54 ; 80, 94) recevant en entrée les sorties du comparateur de phase (38, 52 ; 78, 92) et fournissant en sortie une tension de commande du bloc (34 ; 74) de conversion de fréquence, et
- chaque autre circuit d'asservissement (50 ; 90) est raccordé au premier circuit d'asservissement (32 ; 72) en sortie de leurs pompes de charges (40, 54 ; 80, 94) respectives pour réaliser la commande en tension du bloc (34 ; 74) de conversion de fréquence et comporte en outre des moyens (60 ; 102) de déconnexion de ce raccordement pour une déconnexion de tous les circuits d'asservissement (50 ; 90) sauf le premier (32 ; 72) de la commande en tension du bloc (34 ; 74) de conversion de fréquence, lorsque la phase d'accrochage est terminée.

2. Dispositif (30 ; 70) de synthèse de fréquence selon la revendication 1, comportant :
- N circuits d'asservissement (32, 50 ; 72, 90) pour la commande en tension du bloc (34 ; 74) de conversion de fréquence et N circuits de rétroaction (36, 48 ; 76, 88), le bloc (34 ; 74) de conversion de fréquence étant conçu pour fournir respectivement N signaux (S1, S2) déphasés successivement entre eux de 2π/N aux N circuits d'asservissement (32, 50 ; 72, 90) par l'intermédiaire des N circuits de rétroaction (36, 48 ; 76, 88),
- au moins une source (56, 96) de fréquence de référence conçue pour fournir respectivement N signaux de référence (SR1, SR2) déphasés successivement entre eux de 2π/N aux N circuits d'asservissement (32, 50 ; 72, 90).

3. Dispositif (30 ; 70) de synthèse de fréquence selon la revendication 2, comportant :
- deux circuits d'asservissement (32, 50 ; 72, 90) et deux circuits de rétroaction (36, 48 ; 76, 88), le bloc (34 ; 74) de conversion de fréquence étant conçu pour fournir respectivement deux signaux (S1, S2) en opposition de phase aux deux circuits d'asservissement (32, 50 ; 72, 90) par l'intermédiaire des deux circuits de rétroaction (36, 48 ; 76, 88),
- au moins une source (56, 96) de fréquence de référence conçue pour fournir respectivement deux signaux de référence (SR1, SR2) en opposition de phase aux deux circuits d'asservissement (32, 50 ; 72, 90).

4. Dispositif (30 ; 70) de synthèse de fréquence selon la revendication 2 ou 3, comportant une source de fréquence à quartz (56 ; 96) et un diviseur (58 ; 98) du signal fourni par la source de fréquence à quartz (56 ; 96) pour la fourniture des N signaux de référence (SR1, SR2) aux N circuits d'asservissement (32, 50 ; 72, 90).

5. Dispositif (30) de synthèse de fréquence selon l'une quelconque des revendications 1 à 4, de type boucle à verrouillage de phase dite PLL, dans lequel le bloc (34) de conversion de fréquence comporte un oscillateur commandé en tension (44) disposé en sortie des circuits d'asservissement (32, 50) et un diviseur de tension (46) connecté entre l'oscillateur commandé en tension (44) et les circuits de rétroaction (36, 48).

6. Dispositif de synthèse de fréquence selon la revendication 5, comportant en outre un filtre (42) disposé en entrée de l'oscillateur commandé en tension (44).

7. Dispositif (70) de synthèse de fréquence selon l'une quelconque des revendications 1 à 6, de type boucle à verrouillage de retard dite DLL, dans lequel le bloc (74) de conversion de fréquence comporte une ligne à retard commandée en tension (84) disposée en sortie des circuits d'asservissement (72, 90) et fournissant en sortie des signaux déphasés dont au moins une partie (S1, S2) est fournie aux circuits de rétroaction (76, 88) et un multiplicateur de fréquence (86) disposé pour recevoir les signaux déphasés de la ligne à retard commandée en tension (84) et fournir un signal de sortie à fréquence démultipliée.

8. Dispositif (70) de synthèse de fréquence selon la revendication 7, comportant en outre un bloc condensateur de lissage (82) disposé en entrée de la ligne à retard commandée en tension (84) et dans lequel sont susceptibles d'être injectées ou retirées des charges par chaque pompe de charges (80, 94) de chaque circuit d'asservissement (72, 90) grâce au raccordement de chaque autre circuit d'asservissement (90) au premier circuit d'asservissement (72).

## Patentansprüche

1. Vorrichtung (30; 70) für Rückkopplungsschleifen-Frequenzsynthese, Folgendes beinhaltend:
- eine erste Ansteuerungsschaltung (32; 72) mit Phasenvergleich, die ein erstes Referenzsignal mit einer Referenzfrequenz empfängt, einen Frequenzumwandlungsblock (34; 74), der von der ersten Ansteuerungsschaltung (32; 72) spannungsgesteuert ist, und für die Bereitstellung eines Ausgangssignals mit einer vielfachen Ausgangsfrequenz der Referenzfrequenz gestaltet ist, und eine Rückkopplungsschaltung (36; 76) zum Bereitstellen mindestens eines Signals (S1), das aus dem Frequenzumwandlungsblock (34; 74) stammt, für die erste Ansteuerungsschaltung (32; 72),
- mindestens eine weitere Ansteuerungsschaltung (50; 90), die mindestens ein weiteres Referenzsignal mit der Referenzfrequenz für die Steuerung des Frequenzumwandlungsblocks (34; 74) empfängt, und mindestens eine weitere Rückkopplungsschaltung (48; 88) zum Bereitstellen mindestens eines weiteren Signals (S2), das aus dem Frequenzumwandlungsblock (34; 74) stammt, für diese weitere Ansteuerungsschaltung (50; 90),
**dadurch gekennzeichnet, dass**
- das erste Referenzsignal und das weitere Referenzsignal zueinander um eine vorbestimmte Phasenverschiebung phasenverschoben sind,
- die Signale (S1, S2), die aus dem Frequenzumwandlungsblock (34; 74) stammen, um dieselbe vorbestimmte Phasenverschiebung voneinander phasenverschoben sind,
wobei jede Ansteuerungsschaltung (32, 50; 72, 90) einen Phasenvergleicher (38, 52; 78, 92) mit zwei Ausgängen beinhaltet, der am Eingang das eine der Referenzsignale (SR1, SR2) und dessen entsprechendes Signal (S1, S2), das aus dem Frequenzumwandlungsblock (34; 74) stammt, das von der entsprechenden Rückkopplungsschaltung (36, 48; 76, 88) bereitgestellt wird, empfängt,
- wobei jede Ansteuerungsschaltung (32, 50; 72, 90) weiter eine Ladepumpe (40, 54; 80, 94) beinhaltet, die am Eingang die Ausgänge des Phasenvergleichers (38, 52; 78, 92) empfängt und am Ausgang eine Steuerspannung des Frequenzumwandlungsblocks (34; 74) bereitstellt, und
- jede weitere Ansteuerungsschaltung (50; 90) an der ersten Ansteuerungsschaltung (32; 72) am Ausgang von deren entsprechenden Ladepumpen (40, 54; 80, 94) angeschlossen ist, um die Spannungssteuerung des Frequenzumwandlungsblocks (34; 74) zu realisieren, und weiter Mittel (60; 102) zum Trennen dieses Anschlusses zum Trennen aller Ansteuerungsschaltungen (50; 90) mit Ausnahme der ersten (32; 72) der Spannungssteuerung des Frequenzumwandlungsblocks (34; 74) beinhaltet, wenn die Anhängephase abgeschlossen ist.

2. Vorrichtung (30; 70) für Frequenzsynthese nach Anspruch 1, Folgendes beinhaltend:
- N Ansteuerungsschaltungen (32, 50; 72, 90) zur Spannungssteuerung des Frequenzumwandlungsblocks (34; 74) und N Rückkopplungsschaltungen (36, 48; 76, 88), wobei der Frequenzumwandlungsblock (34; 74) gestaltet ist, um jeweils N Signale (S1, S2), die nacheinander um 2*π*/N voneinander phasenversetzt sind, für die N Ansteuerungsschaltungen (32, 50; 72, 90) über die N Rückkopplungsschaltungen (36, 48; 76, 88) bereitzustellen,
- mindestens eine Referenzfrequenzquelle (56, 96), die gestaltet ist, um jeweils N Referenzsignale (SR1, SR2), die nacheinander um 2*π*/N voneinander phasenversetzt sind, für die N Ansteuerungsschaltungen (32, 50; 72, 90) bereitzustellen.

3. Vorrichtung (30; 70) für Frequenzsynthese nach Anspruch 2, Folgendes beinhaltend:
- zwei Ansteuerungsschaltungen (32, 50; 72, 90) und zwei Rückkopplungsschaltungen (36, 48; 76, 88), wobei der Frequenzumwandlungsblock (34; 74) gestaltet ist, um jeweils zwei Signale (S1, S2) mit Gegenphasen für die beiden Ansteuerungsschaltungen (32, 50; 72, 90) über die beiden Rückkopplungsschaltungen (36, 48; 76, 88) bereitzustellen,
- mindestens eine Referenzfrequenzquelle (56, 96), die gestaltet ist, um jeweils zwei Referenzsignale (SR1, SR2) mit Gegenphasen für die beiden Ansteuerungsschaltungen (32, 50; 72, 90) bereitzustellen.

4. Vorrichtung (30; 70) für Frequenzsynthese nach Anspruch 2 oder 3, eine Quarzfrequenzquelle (56; 96) und einen Teiler (58; 98) des Signals beinhaltend, das durch die Quarzfrequenzquelle (56; 96) bereitgestellt wird, für die Bereitstellung der N Referenzsignale (SR1, SR2) für die N Ansteuerungsschaltungen (32, 50; 72, 90).

5. Vorrichtung (30) für Frequenzsynthese nach einem der Ansprüche 1 bis 4, vom Typ Schleife mit Phasenverriegelung, PLL genannt, wobei der Frequenzumwandlungsblock (34) einen spannungsgesteuerten Oszillator (44) beinhaltet, der am Ausgang der Ansteuerungsschaltungen (32, 50) angeordnet ist, und einen Spannungsteiler (46), der zwischen dem spannungsgesteuerten Oszillator (44) und den Rückkopplungsschaltungen (36, 48) verbunden ist.

6. Vorrichtung für Frequenzsynthese nach Anspruch 5, weiter einen Filter (42) beinhaltend, der am Eingang des spannungsgesteuerten Oszillators (44) angeordnet ist.

7. Vorrichtung (70) für Frequenzsynthese nach einem der Ansprüche 1 bis 6, vom Typ Schleife mit Verzögerungsverriegelung, DLL genannt, wobei der Frequenzumwandlungsblock (74) eine spannungsgesteuerte Verzögerungsleitung (84) beinhaltet, die am Ausgang der Ansteuerungsschaltungen (72, 90) angeordnet ist, und am Ausgang phasenversetzte Signale bereitstellt, von denen mindestens ein Teil (S1, S2) für die Rückkopplungsschaltungen (76, 88) bereitgestellt ist, und einen Frequenzmultiplikator (86), der angeordnet ist, um die phasenversetzten Signale der spannungsgesteuerten Verzögerungsleitung (84) zu empfangen und ein Ausgangssignal mit gesteigerter Frequenz bereitzustellen.

8. Vorrichtung (70) für Frequenzsynthese nach Anspruch 7, weiter einen Glättungskondensatorblock (82) beinhaltend, der am Eingang der spannungsgesteuerten Verzögerungsleitung (84) angeordnet ist, und in den/ aus dem Ladungen durch jede Ladepumpe (80, 94) jeder Ansteuerungsschaltung (72, 90) dank des Anschlusses jeder weiteren Ansteuerungsschaltung (90) an die erste Ansteuerungsschaltung (72) injiziert oder abgezogen werden können.

## Claims

1. Frequency synthesis device (30; 70) with feedback loop, comprising:
- a first control circuit (32; 72) with phase comparison receiving a first reference signal at a reference frequency, a frequency conversion unit (34; 74) voltage controlled by the first control circuit (32; 72) and designed for supplying an output signal at an output frequency that is a multiple of the reference frequency, and a feedback circuit (36; 76) for supplying at least one signal (S1) issuing from the frequency conversion unit (34; 74) to the first control circuit (32; 72),
- at least one other control circuit (50; 90) receiving at least one other reference signal at the reference frequency for the voltage control of the frequency conversion unit (34; 74) and at least one other feedback circuit (48; 88) for supplying at least one other signal (S2) issuing from the frequency conversion unit (34; 74) to this other control circuit (50; 90),
**characterized in that**
- said first reference signal and said other reference signal being phase shifted between each other with a predetermined phase shift,
- said signals (S1, S2) issuing from the frequency conversion unit (34; 74) being phase shifted between each other with the same predetermined phase shift,
wherein each control circuit (32, 50; 72, 90) comprises a phase comparator (38, 52; 78, 92) with two outputs receiving as an input one of the reference signals (SR1, SR2) and the corresponding signal (S1, S2) thereof issuing from the frequency conversion unit (34; 74) supplied by the corresponding feedback loop (36, 48; 76, 88),
- each control circuit (32, 50; 72, 90) further comprises a charge pump (40, 54; 80, 94) receiving as an input the outputs of the phase comparator (38, 52; 78, 92) and supplying as an output a control voltage of the frequency conversion unit (34; 74), and
- each other control circuit (50; 90) is connected to the first control circuit (32; 72) at the outputs of their respective charge pumps (40, 54; 80, 94) for performing the control voltage of the frequency conversion unit (34; 74) and further comprises means (60; 102) for disconnecting this connection in order to disconnect all the control circuits (50; 90) except the first one (32; 72) from the control voltage of the frequency conversion unit (34; 74), when the engagement phase is over.

2. Frequency synthesis device (30; 70) according to claim 1, comprising:
- N control circuits (32, 50; 72, 90) for the voltage control of the frequency conversion unit (34; 74) and N feedback circuits (36, 48; 76, 88), the frequency conversion unit (34; 74) being designed to supply respectively N signals (S1, S2) out of phase successively with each other by 2π/N to the N control circuits (32, 50; 72, 90) by means of the N feedback circuits (36, 48; 76, 88),
- at least one reference frequency source (56, 96) designed to supply respectively N reference signals (SR1, SR2) out of phase successively with each other by 2π/N to the N control circuits (32, 50; 72, 90).

3. Frequency synthesis device (30; 70) according to claim 2, comprising:
- two control circuits (32, 50; 72, 90) and two feedback circuits (36, 48; 76, 88), the frequency conversion unit (34; 74) being designed to supply respectively two signals (S1, S2) in phase opposition to the two control circuits (32, 50; 72, 90) by means of the two feedback circuits (36, 48; 76, 88),
- at least one reference frequency source (56; 96) designed to supply respectively two reference signals (SR1, SR2) in phase opposition to the two control circuits (32, 50; 72, 90).

4. Frequency synthesis device (30; 70) according to claim 2 or 3, comprising a quartz crystal frequency source (56; 96) and a divider (58; 98) dividing the signal supplied by the quartz crystal frequency source (56; 96) for supplying the N reference signals (SR1, SR2) to the N control circuits (32, 50; 72, 90).

5. Frequency synthesis device (30) according to any one of claims 1 to 4, of the phase locked loop (PLL) type, wherein the frequency conversion unit (34) comprises a voltage-controlled oscillator (44) placed at the output of the control circuits (32, 50) and a voltage divider (46) connected between the voltage-controlled oscillator (44) and the feedback circuits (36, 48).

6. Frequency synthesis device according to claim 5, further comprising a filter (42) placed at the input of the voltage-controlled oscillator (44).

7. Frequency synthesis device (70) according to any one of claims 1 to 6, of the delay locked loop (DLL) type, wherein the frequency conversion unit (74) comprises a voltage-controlled delay line (84) placed at the output of the control circuits (72, 90) and supplying as an output out-of-phase signals at least some (S1, S2) of which are supplied to the feedback circuits (76, 88), and a frequency multiplier (86) arranged so as to receive the out-of-phase signals from the voltage-controlled delay line (84) and to supply an output signal at demultiplied frequency.

8. Frequency synthesis device (70) according to claim 7, further comprising a smoothing capacitor unit (82) placed at the input of the voltage-controlled delay line (84) and in which charges may be injected or removed by each charge pump (80, 94) of each control circuit (72, 90) thanks to the connection of each other control circuit (90) to the first control circuit (72).
